# EUROPEAN PATENT APPLICATION

(11) **EP 4 429 015 A1**
(43) Date of publication of application: **11.09.2024**
(21) Application number: 21965251.8
(22) Date of filing: 27.11.2021
(51) Int. Cl.: H01P 1/20, H05K 3/34

(54) **DIELECTRIC FILTER AND COMMUNICATION DEVICE**

(71) Applicant: Huawei Technologies Co., Ltd., Shenzhen, Guangdong 518129 (CN)
(72) Inventor: MAO, Chenyang, Shenzhen, Guangdong 518129 (CN); GAO, Yanyan, Shenzhen, Guangdong 518129 (CN); FAN, Gongshu, Shenzhen, Guangdong 518129 (CN); YANG, He, Shenzhen, Guangdong 518129 (CN)
(74) Representative: Körber, Martin Hans
(86) International application number: PCT/CN2021/133770
(87) International publication number: WO 2023/092518

(57) **Abstract**

This application provides a dielectric filter and a communication device. The dielectric filter includes a dielectric body and a signal input-output structure. The signal input-output structure includes a metal component and a blind via provided on the dielectric body. The metal component is inserted into the blind via, and a part that is of the metal component and that is inserted into the blind via may be elastically deformable. According to this application, because the part that is of the metal component and that is inserted into the blind via may be elastically deformable, a stress between the metal component and the blind via in the dielectric body may be reduced through deformation of the metal component, to reduce a probability that a soldering joint of the metal component cracks, and improve overall reliability of the dielectric filter.

## Description

### TECHNICAL FIELD

This application relates to the field of communication technologies, and in particular, to a dielectric filter and a communication device.

### BACKGROUND

Dielectric filters are widely used in wireless communication devices, for example, a base station, a satellite communication system, a navigation system, and an electronic countermeasure system, featuring being low in loss, small in size, and weight in light.

Currently, a dielectric filter is usually placed on a printed circuit board (printed circuit board, PCB) by using a dielectric body, and the PCB is connected to the dielectric body through tin soldering. Because a thermal expansion coefficient of the dielectric body and a thermal expansion coefficient of the PCB are different, a long-term temperature cyclic change may cause a soldering joint between a ceramic dielectric and the PCB to crack. As a result, performance of the filter is affected.

### SUMMARY

This application provides a dielectric filter and a communication device, to resolve a problem that a soldering joint between a ceramic dielectric and a PCB cracks.

According to a first aspect, a dielectric filter is provided. The dielectric filter includes: a dielectric body; and a signal input-output structure, and the signal input-output structure includes a metal component and a blind via provided on the dielectric body. The metal component is inserted into the blind via, and a part that is of the metal component and that is inserted into the blind via may be elastically deformable.

According to this solution, the metal component of the signal input-output structure is inserted into the blind via in the dielectric body, and the part that is of the metal component and that is inserted into the blind via may be elastically deformable, so that not only electrical connection and signal transmission can be implemented, but also tolerance of thermal expansion and contraction can be improved. For example, in the conventional technology, the dielectric body is soldered on a PCB. Because a thermal expansion coefficient of the dielectric body and a thermal expansion coefficient of the PCB are different, a long-term temperature cycle test may cause cracking of a soldering joint between the dielectric body and the PCB. Based on this embodiment provided in this application, the signal input-output structure is soldered on the PCB because the signal input-output structure inputs and/or outputs a signal. The part that is of the metal component of the signal input-output structure and that is inserted into the blind via may be elastically deformable. In this way, relative motions between the metal component and the PCB that may be caused by different thermal expansion coefficients of the metal component and the PCB may be absorbed through deformation of the metal component. This reduces deformation caused by mismatched positions of a soldering joint between the metal component and the PCB, reduces a probability that the soldering joint between the metal component and the PCB cracks, and improves overall reliability of the dielectric filter.

With reference to the first aspect, in some implementations of the first aspect, the signal input-output structure includes a signal input structure and/or a signal output structure. That is, the signal input-output structure may be used for signal input and/or signal output.

According to this solution, the metal component of the signal input structure is inserted into the blind via in the dielectric body, and the part that is of the metal component and that is inserted into the blind via may be elastically deformable. Alternatively, the metal component of the signal output structure is inserted into the blind via in the dielectric body, and the part that is of the metal component and that is inserted into the blind via may be elastically deformable.

With reference to the first aspect, in some implementations of the first aspect, a surface that is of the metal component and that is away from the blind via is flush with a surface of the dielectric body.

According to this solution, the surface that is of the metal component and that is away from the blind via is flush with the surface of the dielectric body. In this way, the metal component can be soldered on the PCB, and a size of the metal component can be reduced, to reduce manufacturing costs of the metal component.

With reference to the first aspect, in some implementations of the first aspect, a surface that is of the metal component and that is away from the blind via is higher than a surface of the dielectric body.

According to this solution, the surface that is of the metal component and that is away from the blind via is higher than the surface of the dielectric body. In this way, the metal component can be soldered on the PCB. In addition, when the dielectric body is soldered on the PCB, because the surface of the metal component is higher than the surface of the dielectric body, the metal component can be easily soldered on the PCB.

With reference to the first aspect, in some implementations of the first aspect, the metal component further includes a limiting structure, and the limiting structure is configured to limit a depth of inserting the metal component into the blind via.

With reference to the first aspect, in some implementations of the first aspect, the limiting structure is a step-like structure.

According to this solution, a structure of the metal component is designed as a step-like structure, and a limiting function may be implemented by using the structure of the metal component.

With reference to the first aspect, in some implementations of the first aspect, a groove or a hole is provided on the part that is of the metal component and that is inserted into the blind via.

In this solution, an opening is provided on the part that is of the metal component and that is inserted into the blind via, that is, an opening is provided at one end that is of the metal component and that fits the blind via. For example, the groove or the hole is opened at the end that is of the metal component and that fits the blind via. In this way, elastic deformation of the metal component can be implemented by using the groove or the hole. The elastic deformation absorbs relative motions between the metal component and the PCB that may be caused by different thermal expansion coefficients, so that deformation caused by mismatched positions of the soldering joint between the metal component and the PCB is reduced, and further, cracking can be reduced. For example, if the metal component has thermal expansion, the end of the metal component at which the opening is provided may be deformed outward to adapt to the thermal expansion of the metal component and prevent the soldering joint between the metal component and the PCB from cracking; or if the metal component has thermal contraction, the end of the metal component at which the opening is provided may be deformed inward to adapt to the thermal contraction of the metal component and prevent the soldering joint between the metal component and the PCB from cracking.

With reference to the first aspect, in some implementations of the first aspect, an outer diameter of the part that is of the metal component and that is inserted into the blind via is greater than a diameter of the blind via.

According to this solution, an outer diameter of the part that is of the metal component and that is inserted into the blind via may be greater than the diameter of the blind via, that is, the metal component and the blind via may be connected in an interference fit manner. In this way, after the metal component is inserted into the blind via, the metal component can be prevented from falling off.

With reference to the first aspect, in some implementations of the first aspect, the metal component is inserted into the blind via through interference.

With reference to the first aspect, in some implementations of the first aspect, the dielectric filter further includes a grounding structure, the grounding structure is inserted into a slot provided on the dielectric body, and a part that is of the grounding structure and that is inserted into the slot may be elastically deformable.

In this solution, the dielectric filter includes the grounding structure, the grounding structure is inserted into the slot in the dielectric body, and the part that is of the grounding structure and that is inserted into the slot may be elastically deformable, so that tolerance of thermal expansion and contraction can be improved. For example, in the conventional technology, the dielectric body is soldered on a PCB. Because a thermal expansion coefficient of the dielectric body and a thermal expansion coefficient of the PCB are different, a long-term temperature cycle test may cause cracking of a soldering joint (for example, a grounding soldering j oint) between the dielectric body and the PCB. Based on embodiments provided in this application, a grounding structure is provided. The grounding structure is soldered on the PCB. The part that is of the grounding structure and that is inserted into the slot may be elastically deformable. In this way, relative motions between the grounding structure and the PCB that may be caused by different thermal expansion coefficients of the grounding structure and the PCB may be absorbed through deformation of the grounding structure. This reduces deformation caused by mismatched positions of the soldering joint between the grounding structure and the PCB, reduces a probability that the soldering joint between the grounding structure and the PCB cracks, and improves overall reliability of the dielectric filter.

With reference to the first aspect, in some implementations of the first aspect, the grounding structure fully or half surrounds a periphery of the signal input-output structure.

With reference to the first aspect, in some implementations of the first aspect, a surface that is of the grounding structure and that is away from the slot is flush with the surface of the dielectric body.

According to this solution, the surface that is of the grounding structure and that is away from slot is flush with the surface of the dielectric body. In this way, the grounding structure can be soldered on the PCB, and a size of the grounding structure can be reduced, to reduce manufacturing costs of the grounding structure.

With reference to the first aspect, in some implementations of the first aspect, a surface that is of the grounding structure and that is away from the slot is higher than the surface of the dielectric body.

According to this solution, the surface that is of the grounding structure and that is away from the slot is higher than the surface of the dielectric body. In this way, the grounding structure can be soldered on the PCB. In addition, when the dielectric body is soldered on the PCB, because the surface of the grounding structure is higher than the surface of the dielectric body, the grounding structure can be easily soldered on the PCB.

With reference to the first aspect, in some implementations of the first aspect, a groove or a hole is provided on the part that is of the grounding structure and that is inserted into the slot.

In this solution, an opening is provided on the part that is of the grounding structure and that is inserted into the slot, that is, an opening is provided at one end that is of the grounding structure and that fits the slot. For example, the groove or the hole is opened at the end that is of the grounding structure and that fits the slot. In this way, elastic deformation of the grounding structure can be implemented by using the groove or the hole. The elastic deformation absorbs relative motions between the grounding structure and the PCB that may be caused by different thermal expansion coefficients, so that deformation caused by mismatched positions of the soldering joint between the grounding structure and the PCB is reduced, and further, cracking can be reduced. For example, if the grounding structure has thermal expansion, the end of the grounding structure at which the opening is provided may be deformed outward to adapt to the thermal expansion of the grounding structure and prevent the soldering joint between the grounding structure and the PCB from cracking; or if the grounding structure has thermal contraction, the end of the grounding structure at which the opening is provided may be deformed inward to adapt to the thermal contraction of the grounding structure and prevent the soldering joint between the grounding structure and the PCB from cracking.

With reference to the first aspect, in some implementations of the first aspect, a width of the part that is of the grounding structure and that is inserted into the slot is greater than a width of the slot.

In this solution, the width of the part that is of the grounding structure and that is inserted into the slot may be greater than a width of the slot. In other words, the grounding structure and the slot may be connected in an interference fit manner. In this way, after the grounding structure is inserted into the slot, the grounding structure can be prevented from falling off.

With reference to the first aspect, in some implementations of the first aspect, the grounding structure is inserted into the slot through interference.

According to a second aspect, a dielectric filter is provided. The dielectric filter includes: a dielectric body; and a grounding structure. The grounding structure is inserted into a slot provided on the dielectric body, and a part that is of the grounding structure and that is inserted into the slot is elastically deformable.

In this solution, the dielectric filter includes the grounding structure, the grounding structure is inserted into the slot in the dielectric body, and the part that is of the grounding structure and that is inserted into the slot may be elastically deformable, so that tolerance of thermal expansion and contraction can be improved. For example, in the conventional technology, the dielectric body is soldered on a PCB. Because a thermal expansion coefficient of the dielectric body and a thermal expansion coefficient of the PCB are different, a long-term temperature cycle test may cause cracking of a soldering joint (for example, a grounding soldering j oint) between the dielectric body and the PCB. Based on embodiments provided in this application, a grounding structure is provided. The grounding structure is soldered on the PCB. The part that is of the grounding structure and that is inserted into the slot may be elastically deformable. In this way, relative motions between the grounding structure and the PCB that may be caused by different thermal expansion coefficients of the grounding structure and the PCB may be absorbed through deformation of the grounding structure. This reduces deformation caused by mismatched positions of the soldering joint between the grounding structure and the PCB, reduces a probability that the soldering joint between the grounding structure and the PCB cracks, and improves overall reliability of the dielectric filter.

With reference to the second aspect, in some implementations of the second aspect, the filter further includes a signal input-output structure, and the grounding structure fully or half surrounds a periphery of the signal input-output structure.

With reference to the second aspect, in some implementations of the second aspect, a surface that is of the grounding structure and that is away from the slot is flush with a surface of the dielectric body, or a surface that is of the grounding structure and that is away from the slot is higher than a surface of the dielectric body.

With reference to the second aspect, in some implementations of the second aspect, a groove or a hole is provided on the part that is of the grounding structure and that is inserted into the slot.

With reference to the second aspect, in some implementations of the second aspect, a width of the part that is of the grounding structure and that is inserted into the slot is greater than a width of the slot.

With reference to the second aspect, in some implementations of the second aspect, the grounding structure is inserted into the slot through interference.

According to a third aspect, a communication device is provided. The communication device includes the dielectric filter provided in the first aspect or the second aspect.

With reference to the third aspect, in some implementations of the third aspect, the communication device is a network device.

With reference to the third aspect, in some implementations of the third aspect, the communication device is a terminal device.

### BRIEF DESCRIPTION OF DRAWINGS

FIG. 1 is a diagram of a structure of a ceramic dielectric filter in the conventional technology;
FIG. 2 is a three-dimensional diagram of a dielectric filter according to an embodiment of this application;
FIG. 3 is a schematic front view of a dielectric filter according to an embodiment of this application;
FIG. 4 is a schematic top view of a dielectric filter according to an embodiment of this application;
FIG. 5 is a diagram of a metal component according to an embodiment of this application;
FIG. 6 is another diagram of a metal component according to an embodiment of this application;
FIG. 7 is still another diagram of a metal component according to an embodiment of this application;
FIG. 8 is a diagram of a grounding structure according to an embodiment of this application; and
FIG. 9 is another diagram of a grounding structure according to an embodiment of this application.

### DESCRIPTION OF EMBODIMENTS

The following describes technical solutions of this application with reference to accompanying drawings.

The technical solutions in embodiments of this application may be applied to various communication devices, for example, a wireless communication device including a filter. For example, a dielectric filter provided in embodiments of this application may be applied to a network device or a terminal device in a wireless communication system, for example, a network device or a terminal device in a fifth generation (5th generation, 5G) system or a new radio (new radio, NR) system, for example, a base station, a baseband unit (baseband unit, BU), a distributed unit (distributed unit, DU), or a radio unit (radio unit, RU), or may be applied to a communication device in a future communication system, for example, a communication device in a sixth generation (6th generation, 6G) mobile communication system.

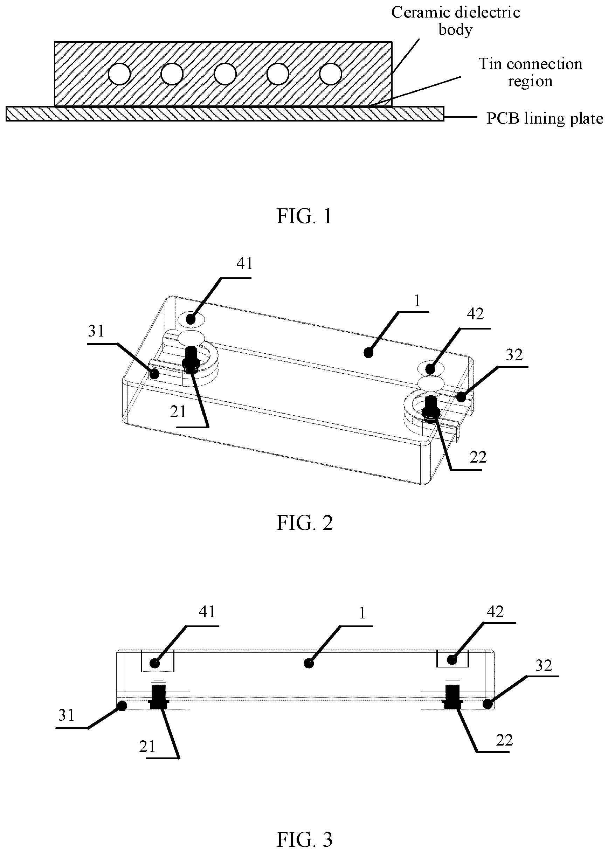

FIG. 1 is a diagram of a structure of a ceramic dielectric filter in the conventional technology.

As shown in FIG. 1, the ceramic dielectric filter includes: a ceramic dielectric body and a printed circuit board (printed circuit board, PCB). The ceramic dielectric body is placed on a PCB, and the PCB is connected to the ceramic dielectric body through tin soldering. A spacer may be further disposed between the PCB and the ceramic dielectric body, and the spacer may be used to solder the PCB and the ceramic dielectric body together by using a soldering holder.

A thermal expansion coefficient of the ceramic dielectric is different from a thermal expansion coefficient of the PCB. For example, the thermal expansion coefficient of the ceramic dielectric is approximately 9, and the thermal expansion coefficient of the PCB is approximately 15 to 17. Because the thermal expansion coefficient of the ceramic dielectric mismatches the thermal expansion coefficient of the PCB, cracking may occur on a soldering joint (for example, a ground soldering j oint, or a soldering joint used for signal input and output) between the dielectric body and the PCB in a long-term temperature cyclic change, and a life of the filter is affected.

In view of this, this application provides a solution, to resolve a problem that a soldering joint between a dielectric body and a PCB cracks in a long-term temperature cyclic change.

Embodiments provided in this application are described below in detail with reference to the accompanying drawings.

It should be understood that, in embodiments of this application, "up", "down", "left", "right", and similar descriptions are merely for description, and do not represent a unique implementation.

FIG. 2 is a three-dimensional diagram of a dielectric filter according to an embodiment of this application. FIG. 2 is merely a diagram for ease of understanding, and a specific structure of an actual product is not limited by FIG. 2.

As shown in FIG. 2, the dielectric filter includes a dielectric body 1. As an example, the dielectric body 1 may be pressed and molded in an integrated manner by using a ceramic material. In this manner, the process is mature and difficult. It may be understood that a material and a manufacturing process used by the dielectric body 1 are not limited.

In a solution provided in embodiments of this application, the dielectric filter includes a dielectric body 1 and a signal input-output structure. The signal input-output structure includes a metal component and a blind via provided on the dielectric body 1. For example, a metal component 21 and a metal component 22 are included. The metal component is inserted into the blind via, and a part that is of the metal component and that is inserted into the blind via may be elastically deformable.

According to this solution, the metal component of the signal input-output structure is inserted into the blind via in the dielectric body 1, and the part that is of the metal component and that is inserted into the blind via may be elastically deformable, so that not only electrical connection and signal transmission can be implemented, but also tolerance of thermal expansion and contraction can be improved. For example, in the conventional technology, the dielectric body is soldered on a PCB. Because a thermal expansion coefficient of the dielectric body and a thermal expansion coefficient of the PCB are different, a long-term temperature cycle test may cause cracking of a soldering joint between the dielectric body and the PCB. Based on this embodiment provided in this application, the signal input-output structure is soldered on the PCB because the signal input-output structure inputs and/or outputs a signal. The part that is of the metal component of the signal input-output structure and that is inserted into the blind via may be elastically deformable. In this way, relative motions between the metal component and the PCB that may be caused by different thermal expansion coefficients of the metal component and the PCB may be absorbed through deformation of the metal component. This reduces deformation caused by mismatched positions of a soldering joint between the metal component and the PCB, reduces a probability that the soldering joint between the metal component and the PCB cracks, and improves overall reliability of the dielectric filter.

It may be understood that the signal input-output structure may include a structure formed after the metal component is inserted into the blind via.

The part that is of the metal component and that is inserted into the blind via may be elastically deformable, that is, the part that is of the metal component and that is inserted into the blind via can be deformed. For example, a shape of the metal component (for example, a shape of the part that is of the metal component and that is inserted into the blind via) may be designed, so that the part that is of the metal component and that is inserted into the blind via can be elastically deformable.

Optionally, the metal material for preparing the metal component may be any one or more of the following: silver paste, silver, tin, copper, nickel, and an alloy (for example, a sheet alloy). This is not limited in this application. For example, the metal component is a pin (PIN) needle.

The signal input-output structure is a structure that can implement signal input and/or output. The example shown in FIG. 2 includes two signal input-output structures (that is, the metal component 21 and the blind via in which the metal component 21 is located, and the metal component 22 and a blind via in which the metal component 22 is located), where one is used for signal input and the other is used for signal output. It may be understood that this embodiment of this application may also be used for a dielectric filter including only one signal input-output structure. In this case, the signal input-output structure may be used for signal input and output.

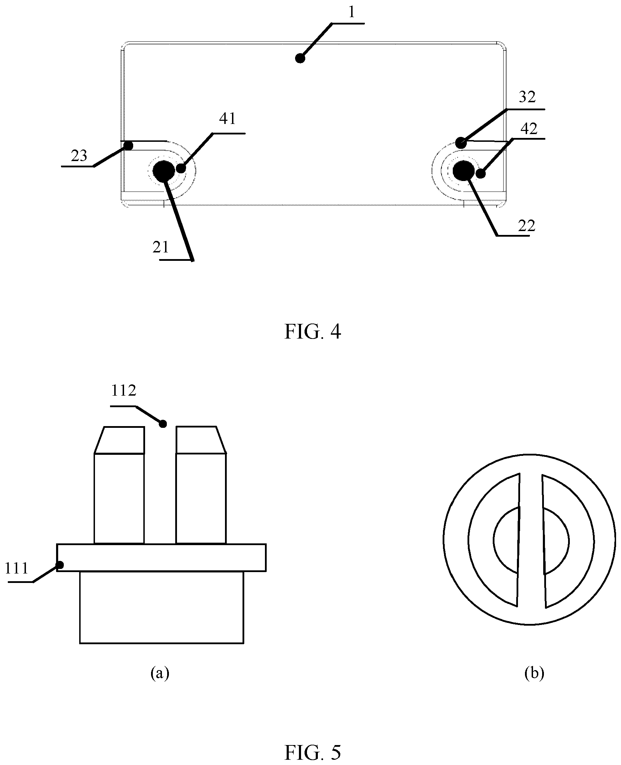

FIG. 3 is a schematic front view of a dielectric filter according to an embodiment of this application. FIG. 4 is a schematic top view of a dielectric filter according to an embodiment of this application. FIG. 3 is a front view of the dielectric filter shown in FIG. 2, and FIG. 4 is a top view of the dielectric filter shown in FIG. 2. It can be seen from FIG. 3 or FIG. 4 that the metal component 21 (for example, a metal component in a signal input structure) is inserted into one blind via in the dielectric body 1, and the metal component 22 (for example, a metal component in a signal output structure) is inserted into another blind via in the dielectric body 1.

Optionally, a surface that is of the metal component and that is away from the blind via is flush with a surface of the dielectric body, or a surface that is of the metal component and that is away from the blind via is higher than a surface of the dielectric body.

As shown in FIG. 3, a surface (that is, a lower surface) that is of the metal component 21 and that is away from the blind via is higher than the surface (that is, a lower surface) of the dielectric body 1, and a surface (that is, a lower surface) that is of the metal component 22 and that is away from the blind via is higher than the surface (that is, the lower surface) of the dielectric body 1. In this way, when the dielectric filter is soldered on the PCB, the metal component 21 and the metal component 22 may also be soldered on the PCB, to implement electrical connection and signal transmission.

It may be understood that, the foregoing is an example for description. As long as the metal component can be soldered on the PCB, the surface that is of the metal component and that is away from the blind via may alternatively be lower than the surface of the dielectric body.

Optionally, that the metal component is inserted into the blind via includes: an interference fit (interference fit) between the metal component and the blind via. That is, the metal component is inserted into the blind via in a manner of the interference fit (or insertion through interference), so that the metal component tightly fits the blind via, to prevent the metal component from falling off.

The interference fit is a technology used to implement a connection between two components. Taking the metal component and the blind via as an example, a possible manner of implementing the interference fit between the metal component and the blind via is as follows: The metal component is enabled to shrink and be inserted into the blind via through elasticity of the metal component; and when the metal component is restored, a tightly-holding force is generated to connect the metal component to the blind via. There are many manners for implementing the interference fit, for example, a low-temperature assembly method or a heating assembly method. This is not limited in this embodiment of this application.

An outer diameter of the part that is of the metal component and that is inserted into the blind via may be greater than a diameter of the blind via, that is, the metal component and the blind via may be connected in an interference fit manner. In this way, after the metal component is inserted into the blind via, the metal component can be prevented from falling off.

Optionally, the metal component includes a limiting structure. The limiting structure may be used to limit a depth of inserting the metal component into the blind via.

In a possible design manner, the limiting structure is a step-like structure, for example, a step-like column structure.

Optionally, an opening is provided on the part that is of the metal component and that is inserted into the blind via.

The opening is provided on the part that is of the metal component and that is inserted into the blind via, that is, an opening is provided at one end that is of the metal component and that fits the blind via. For example, a groove or a hole is opened at the end that is of the metal component and that fits the blind via. In this way, deformation of the metal component can be implemented by using the groove or the hole. The deformation absorbs relative motions between the metal component and the PCB that may be caused by different thermal expansion coefficients, so that deformation caused by mismatched positions of the soldering joint between the metal component and the PCB is reduced, and further, cracking can be reduced. For example, if the metal component has thermal expansion, the end of the metal component at which the opening is provided may be deformed outward to adapt to the thermal expansion of the metal component and prevent the soldering joint between the metal component and the PCB from cracking; or if the metal component has thermal contraction, the end of the metal component at which the opening is provided may be deformed inward to adapt to the thermal contraction of the metal component and prevent the soldering joint between the metal component and the PCB from cracking.

A shape of the groove may be, for example, one or more of a strip groove, a circular groove, a cross groove, a T-shaped groove, and an L-shaped groove.

The shape of the hole may be, for example, one or more of a cylindrical hole, a regular polygonal hole, an elliptical hole, a rectangular hole, and an irregular hole.

The following describes examples with reference to FIG. 5 to FIG. 7.

FIG. 5 is a diagram of a metal component according to an embodiment of this application.

As shown in FIG. 5, (a) in FIG. 5 is a three-dimensional diagram of the metal component (for example, the metal component 21 or the metal component 22), and (b) in FIG. 5 is a top view of the metal component.

As shown in FIG. 5, the metal component is designed as a step-like column structure, that is, a boss 111 may be provided between a lower end and an upper end of the metal component, and the boss may be configured to limit a depth of inserting the metal component into a blind via. In addition, when the metal component shrinks due to elastic deformation, the metal component may be skewed in the blind via, or even the metal component may fall off. Because of a design of the boss 111, a connection between the metal component and the blind via may be tight, to avoid falling off and skewing of the metal component as much as possible, and improve product quality of the dielectric filter.

As shown in FIG. 5, a groove 112 is opened at the upper end (that is, a part inserted into the blind via) of the metal component, and the lower end (that is, a part not inserted into the blind via) of the metal component is closed. The lower end of the metal component may be of a solid structure. For example, a surface of the solid structure may be a plane, or may be an arc, for example, a sphere, an ellipsoid, a cylinder, a cube, or a three-dimensional structure of an irregular shape. Details are not described again below.

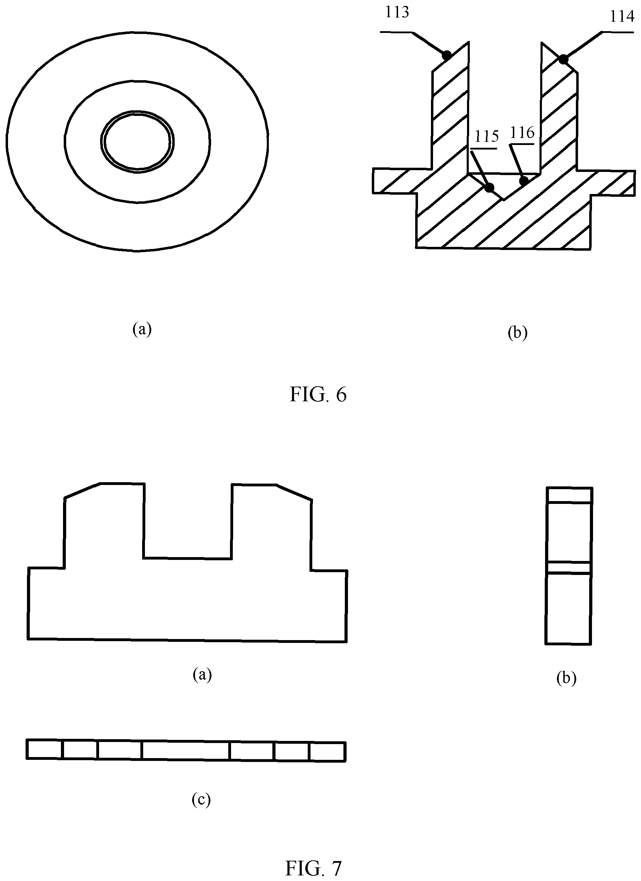

FIG. 6 is another diagram of a metal component according to an embodiment of this application.

As shown in FIG. 6, (a) in FIG. 6 is a top view of a metal component (for example, the metal component 21 or the metal component 22), and (b) in FIG. 6 is a sectional view of the metal component. A difference between FIG. 6 and FIG. 5 lies in that, in the design of FIG. 6, a cylindrical hole is opened at an upper end (that is, a part inserted into a blind via) of the metal component.

FIG. 7 is still another diagram of a metal component according to an embodiment of this application.

As shown in FIG. 7, (a) in FIG. 7 is a front view of a metal component (for example, the metal component 21 or the metal component 22), (b) in FIG. 7 is a side view of the metal component, and (c) in FIG. 7 is a top view of the metal component. A difference between FIG. 7 and FIG. 5 lies in that, in the design of FIG. 7, the metal component includes two parts, and an outer diameter of an upper part (that is, a part inserted into a blind via) is less than a diameter of a lower part (that is, a part not inserted into the blind via). In this way, connectivity between the metal component and the blind via can also be improved, falling off and skewing of the metal component are avoided as much as possible, and product quality of the dielectric filter is improved.

Optionally, a chamfer is provided on an edge of a surface of the metal component. In this way, process difficulty is reduced, press forming is facilitated, and collision damage is reduced. As shown in FIG. 6 or FIG. 7, the chamfer is provided on the edge of the surface of the metal component. For example, a chamfer 113 and a chamfer 114 are provided on an edge of an upper surface of a part of the metal component on which an opening is provided, and a chamfer 115 and a chamfer 116 are provided on an edge of a lower surface of the part of the metal component on which the opening is provided. In this way, when the metal component is inserted into the blind via, the chamfer is provided on the edge of the surface of the part (that is inserted into the blind via) of the metal component on which the opening is provided. In this way, collision damage caused when the metal component is inserted into the blind via can be reduced.

The foregoing mainly describes a first solution, that is, tolerance of thermal expansion and contraction is improved by improving the metal component, and a probability of cracking a soldering joint of the metal component is reduced. The following describes a second solution provided in embodiments of this application.

In the second solution provided in embodiments of this application, as shown in FIG. 2, the dielectric filter includes a dielectric body 1 and a grounding structure, such as a grounding structure 31 and a grounding structure 32. The grounding structure is inserted into a slot (for ease of understanding, the slot is denoted as a grounding slot) provided on the dielectric body 1, and a part that is of the grounding structure and that is inserted into the grounding slot may be elastically deformable.

In this solution, the dielectric filter includes the grounding structure, the grounding structure is inserted into the slot (for example, denoted as a grounding slot) in the dielectric body 1, and the part that is of the grounding structure and that is inserted into the grounding slot may be elastically deformable, to improve tolerance of thermal expansion and contraction. For example, in the conventional technology, the dielectric body is soldered on a PCB. Because a thermal expansion coefficient of the dielectric body and a thermal expansion coefficient of the PCB are different, a long-term temperature cycle test may cause cracking of a soldering joint (for example, a grounding soldering joint) between the dielectric body and the PCB. Based on embodiments provided in this application, a grounding structure is provided. The grounding structure is soldered on the PCB. The part that is of the grounding structure and that is inserted into the slot may be elastically deformable. In this way, relative motions between the grounding structure and the PCB that may be caused by different thermal expansion coefficients of the grounding structure and the PCB may be absorbed through deformation of the grounding structure. This reduces deformation caused by mismatched positions of the soldering joint between the grounding structure and the PCB, reduces a probability that the soldering joint between the grounding structure and the PCB cracks, and improves overall reliability of the dielectric filter.

The grounding structure is a metal structure, and a metal material for preparing the grounding structure may be, for example, any one or more of the following: silver paste, silver, tin, copper, nickel, and an alloy (for example, a sheet alloy). This is not limited in this application.

It may be understood that the grounding structure may include a structure made of the metal material, or may include a structure formed after a structure made of the metal material is inserted into the grounding slot. This is not limited in embodiments of this application.

The grounding structure may be in a plurality of shapes, for example, a column shape, a tubular shape, a ring shape, or an arch shape. This is not limited in this application. Alternatively, the grounding slot may be in a plurality of shapes, for example, a column shape, a tubular shape, a ring shape, or an arch shape. This is not limited in this application. The ring structure may be, for example, a U-shaped structure, a circular ring structure, a square structure, a triangle structure, or an irregular shape. This is not limited in this application.

The part that is of the grounding structure and that is inserted into the grounding slot may be elastically deformable, which indicates that the part that is of the grounding structure and that is inserted into the grounding slot can be deformed. For example, a shape of the grounding structure (for example, a shape of the part that is of the grounding structure and that is inserted into the grounding slot) may be designed, so that the part that is of the grounding structure and that is inserted into the grounding slot may be elastically deformable. Elastic deformation absorbs relative motions between the grounding structure and the PCB that may be caused by different thermal expansion coefficients, so that deformation caused by mismatched positions of the soldering joint between the grounding structure and the PCB is reduced, and further, cracking can be reduced. For example, if the grounding structure has thermal expansion, an end of the grounding structure at which an opening is provided may be deformed outward to adapt to the thermal expansion of the grounding structure and prevent the soldering joint between the grounding structure and the PCB from cracking; or if the grounding structure has thermal contraction, an end of the grounding structure at which an opening is provided may be deformed inward to adapt to the thermal contraction of the grounding structure and prevent the soldering joint between the grounding structure and the PCB from cracking.

Optionally, the grounding structure is located on a periphery of the signal input-output structure. For example, the grounding structure fully or half surrounds a periphery of the signal input-output structure. As shown in FIG. 2 or FIG. 4, it is assumed that the metal component 21 is a metal component in the signal input structure, and the metal component 22 is a metal component in the signal output structure. The grounding structure 31 may be, for example, a U-shaped structure. The grounding structure 31 is inserted into a U-shaped slot (that is, a grounding slot) in the dielectric body 1, and half surrounds a periphery of the signal input structure. The grounding structure 32 may be, for example, a U-shaped structure. The grounding structure 32 is inserted into a U-shaped slot (that is, a grounding slot) in the dielectric body 1, and half surrounds a periphery of the signal output structure.

Optionally, a surface that is of the grounding structure and that is away from the grounding slot is flush with a surface of the dielectric body, or a surface that is of the grounding structure and that is away from the grounding slot is higher than a surface of the dielectric body.

As shown in FIG. 3, a surface (that is, a lower surface) that is of the grounding structure 31 and that is away from the grounding slot is higher than the surface (that is, the lower surface) of the dielectric body 1, and a surface (that is, a lower surface) that is of the grounding structure 32 and that is away from the grounding slot is higher than the surface (that is, the lower surface) of the dielectric body 1. In this way, when the dielectric filter is soldered on the PCB, the grounding structure 31 and the grounding structure 32 may also be soldered on the PCB.

Optionally, that the grounding structure is inserted into the grounding slot includes: The grounding structure and the grounding slot are in an interference fit. Through the interference fit, the grounding structure and the grounding slot can fit tightly, to prevent the grounding structure from falling off. Using the metal component and the blind via as an example, a possible manner of implementing the interference fit between the grounding structure and the grounding slot is as follows: The grounding structure is enabled to shrink and be inserted into the grounding slot through elasticity of the grounding structure; and when the grounding structure is restored, a tightly-holding force is generated, so that the grounding structure is connected to the grounding slot. There are many manners for implementing the interference fit, for example, a low-temperature assembly method or a heating assembly method. This is not limited in this embodiment of this application.

An outer diameter of the part that is of the grounding structure and that is inserted into the grounding slot is greater than a diameter of the grounding slot, that is, the grounding structure and the grounding slot are connected in an interference fit manner. In this way, after the grounding structure is inserted into the grounding slot, the grounding structure can be prevented from falling off. As shown in FIG. 2, a shape of the grounding structure (for example, the grounding structure 31 or the grounding structure 32) is a U-shaped ring, a shape of the grounding slot is a U-shaped slot, and an arm width of the U-shaped ring is greater than an arm width of the U-shaped slot.

It may be understood that the foregoing is an example for description. As long as the grounding structure can be soldered on the PCB, the surface that is of the grounding structure and that is away from the grounding slot may alternatively be lower than the surface of the dielectric body.

Optionally, an opening is provided on the part that is of the grounding structure and that is inserted into the grounding slot.

The opening is provided on the part that is of the grounding structure and that is inserted into the grounding slot, that is, an opening is provided at one end that is of the grounding structure and that fits the grounding slot. For example, a groove or a hole is opened at the end that is of the grounding structure and that fits the grounding slot. In this way, deformation of the grounding structure can be implemented by using the groove or the hole. A shape of the groove may be, for example, one or more of a strip groove, a circular groove, a cross groove, a T-shaped groove, and an L-shaped groove. The shape of the hole may be, for example, one or more of a cylindrical hole, a regular polygonal hole, an elliptical hole, a rectangular hole, and an irregular hole.

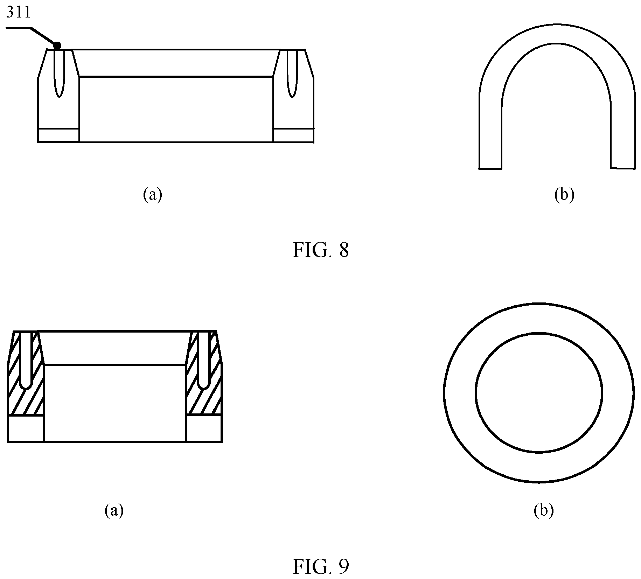

The following describes examples with reference to FIG. 8 to FIG. 9.

FIG. 8 is a diagram of a grounding structure according to an embodiment of this application.

As shown in FIG. 8, (a) in FIG. 8 is a front view of the grounding structure, and (b) in FIG. 8 is a bottom view of the grounding structure.

As shown in FIG. 8, the grounding structure may be in a shape of a U-shaped ring. A groove 311 is opened at an upper end (that is, a part inserted into a grounding slot) of the grounding structure, and a lower end (that is, a part not inserted into the grounding slot) of the grounding structure is closed. The lower end of the grounding structure may be a solid structure. For example, a surface of the solid structure may be a plane, or may be an arc, for example, a sphere, an ellipsoid, a cylinder, a cube, or a three-dimensional structure of an irregular shape. Details are not described again below.

FIG. 9 is another diagram of a grounding structure according to an embodiment of this application.

As shown in FIG. 9, (a) in FIG. 9 is a front view of the grounding structure, and (b) in FIG. 9 is a bottom view of the grounding structure. A difference between FIG. 9 and FIG. 8 lies in that, in the design of FIG. 9, the grounding structure is in a circular ring shape.

Optionally, a chamfer is provided on an edge of a surface of the grounding structure. As shown in FIG. 8 or FIG. 9, the chamfer is provided on the edge of the surface of the grounding structure. In this way, process difficulty is reduced, press forming is facilitated, and collision damage is reduced.

The foregoing separately describes the first solution and the second solution. It may be understood that the foregoing two solutions may be used separately. For example, the signal input-output structure of the dielectric filter is improved, and the grounding structure is formed based on an existing manner. For another example, the grounding structure of the dielectric filter is improved, and the signal input-output structure is formed based on an existing manner. Alternatively, the foregoing two solutions may alternatively be used in combination. For example, both the grounding structure and the signal input-output structure of the dielectric filter are improved.

In addition, there may be some other designs for the dielectric filter.

Optionally, the dielectric filter may be in a shape such as a rectangular block. This is not limited.

Optionally, arc chamfer transition is provided on adjacent surfaces of the dielectric filter. The arc chamfer transition is provided on the adjacent surfaces of the dielectric filter, so that product performance can be optimized, and probability of scratching and touching damage can be reduced.

Optionally, the dielectric filter 2 further includes one or more resonant cavities, and a resonance frequency and a filter pole may be generated by using the one or more resonant cavities.

As shown in FIG. 2, the dielectric filter may further include resonant cavities 41 and 42. The resonant cavities 41 and 42 may be considered as first and last resonant cavities on the dielectric filter respectively, and the signal input-output structure may be coupled to the first and last resonant cavities. The signal input structure includes the metal component 21 and the blind via into which the metal component 21 is inserted, and the signal input structure is configured to be coupled to the resonant cavity 41. The signal output structure includes the metal component 22 and the blind via into which the metal component 22 is inserted, and the signal output structure is configured to be coupled to the resonant cavity 41.

Optionally, the dielectric body 1 is soldered on the PCB. For example, the dielectric body 1 and the PCB may be connected by using evenly arranged tin soldering joints.

Optionally, a spacer is disposed between the dielectric body 1 and the PCB. As an example, the spacer is a silver-plated copper sheet. A thermal expansion coefficient of the spacer is close to a thermal expansion coefficient of the PCB. A quantity of spacers is not limited. For example, there may be four spacers. A thickness of the spacer is not limited, for example, 0.3 mm.

It should be understood that size values mentioned in embodiments of this application are all examples for description, and a requirement on the size may include a specific tolerance range. For example, when the thickness of the spacer is designed, the thickness of the spacer may be (0.3 mm + Δ1). Specific values of Δ1 and Δ2 are not limited.

It should be further understood that specific diagrams of structures of the dielectric filter, the metal component, and the grounding structure provided in embodiments of this application are merely examples for description, and any variation of the foregoing structures is applicable to this application.

An embodiment of this application further provides a communication device. The communication device includes the dielectric filter in the foregoing embodiment.

It should be understood that the communication device may be a network device, for example, the network device may be a base station. The base station may cover various names in a broad sense, or may be replaced with the following names, for example, a NodeB (NodeB), an evolved NodeB (evolved NodeB, eNB), a next generation NodeB (next generation NodeB, gNB), a relay station, an access point, a transmitting and receiving point (transmitting and receiving point, TRP), a transmitting point (transmitting point, TP), a primary station, a secondary station, a multiple standard radio (motor slide retainer, MSR) node, a home base station, a network controller, an access node, a radio node, an access point (access point, AP), a transmission node, a transceiver node, a baseband unit (BU), a radio unit (RU), a remote radio unit (remote radio unit, RRU), an active antenna unit (active antenna unit, AAU), a radio head (remote radio head, RRH a central unit (central unit, CU), a distributed unit (DU), a positioning node, and the like. The base station may be a macro base station, a micro base station, a relay node, a donor node, an analogue, or a combination thereof. The base station may alternatively be a communication module, a modem, or a chip that is disposed in the foregoing device or apparatus. Alternatively, the base station may be a mobile switching center, a device that bears a base station function in device to device (device to device, D2D), vehicle to everything (vehicle-to-everything, V2X), machine to machine (machine to machine, M2M) communication, a network-side device in a 6G network, a device that bears a base station function in a future communication system, or the like. The base station may support networks of a same access technology or different access technologies. A specific technology and a specific device form that are used by the network device are not limited in embodiments of this application.

Alternatively, the communication device may be a terminal device. Currently, examples of some terminal devices are as follows: a mobile phone (mobile phone), a tablet computer, a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self driving (self driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication capability, a computing device or another processing device connected to a wireless modem, a wearable device, a terminal device in a 5G network, a terminal device in a future evolved public land mobile network (public land mobile network, PLMN), and the like. This is not limited in embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims and this specification.

## Claims

1. A dielectric filter, comprising:
a dielectric body; and
a signal input-output structure, wherein the signal input-output structure comprises a metal component and a blind via provided on the dielectric body, the metal component is inserted into the blind via, and a part that is of the metal component and that is inserted into the blind via is elastically deformable.

2. The dielectric filter according to claim 1, wherein the signal input-output structure is configured to input a signal and/or output a signal.

3. The dielectric filter according to claim 1 or 2, wherein
a surface that is of the metal component and that is away from the blind via is flush with a surface of the dielectric body, or a surface that is of the metal component and that is away from the blind via is higher than a surface of the dielectric body.

4. The dielectric filter according to any one of claims 1 to 3, wherein the metal component further comprises a limiting structure, and the limiting structure is configured to limit a depth of inserting the metal component into the blind via.

5. The dielectric filter according to claim 4, wherein the limiting structure is a step-like structure.

6. The dielectric filter according to any one of claims 1 to 5, wherein
a groove or a hole is provided on the part that is of the metal component and that is inserted into the blind via.

7. The dielectric filter according to any one of claims 1 to 6, wherein an outer diameter of the part that is of the metal component and that is inserted into the blind via is greater than a diameter of the blind via.

8. The dielectric filter according to any one of claims 1 to 7, wherein the metal component is inserted into the blind via through interference.

9. The dielectric filter according to any one of claims 1 to 8, further comprising:
a grounding structure, wherein the grounding structure is inserted into a slot provided on the dielectric body, and a part that is of the grounding structure and that is inserted into the slot is elastically deformable.

10. The dielectric filter according to claim 9, wherein the grounding structure fully or half surrounds a periphery of the signal input-output structure.

11. The dielectric filter according to claim 9 or 10, wherein
a surface that is of the grounding structure and that is away from the slot is flush with a surface of the dielectric body, or a surface that is of the grounding structure and that is away from the slot is higher than a surface of the dielectric body.

12. The dielectric filter according to any one of claims 9 to 11, wherein
a groove or a hole is provided on the part that is of the grounding structure and that is inserted into the slot.

13. The dielectric filter according to any one of claims 9 to 12, wherein a width of the part that is of the grounding structure and that is inserted into the slot is greater than a width of the slot.

14. The dielectric filter according to any one of claims 9 to 13, wherein the grounding structure is inserted into the slot through interference.

15. A dielectric filter, comprising:
a dielectric body; and
a grounding structure, wherein the grounding structure is inserted into a slot provided on the dielectric body, and a part that is of the grounding structure and that is inserted into the slot is elastically deformable.

16. The dielectric filter according to claim 15, wherein the filter further comprises a signal input-output structure, and the grounding structure fully or half surrounds a periphery of the signal input-output structure.

17. The dielectric filter according to claim 15 or 16, wherein
a surface that is of the grounding structure and that is away from the slot is flush with a surface of the dielectric body, or a surface that is of the grounding structure and that is away from the slot is higher than a surface of the dielectric body.

18. The dielectric filter according to any one of claims 15 to 17, wherein
a groove or a hole is provided on the part that is of the grounding structure and that is inserted into the slot.

19. The dielectric filter according to any one of claims 15 to 18, wherein a width of the part that is of the grounding structure and that is inserted into the slot is greater than a width of the slot.

20. The dielectric filter according to any one of claims 15 to 19, wherein the grounding structure is inserted into the slot through interference.

21. A communication device, wherein the communication device comprises the dielectric filter according to any one of claims 1 to 20.
